Europäisches Patentamt

European Patent Office

Office européen des brevets

(11) Numéro de publication : **0 329 575 B1**

(12) **FASCICULE DE BREVET EUROPEEN**

(45) Date de publication du fascicule du brevet :
**05.05.93 Bulletin 93/18**

(21) Numéro de dépôt : **89420049.2**

(22) Date de dépôt : **15.02.89**

(51) Int. Cl.⁵ : **H03H 11/04, H04M 15/28**

(54) Circuit de compensation de l'atténuation d'un filtre coupe-bande à des fréquences inférieures à sa fréquence de coupure.

(30) Priorité : **16.02.88 FR 8802176**

(43) Date de publication de la demande :
**23.08.89 Bulletin 89/34**

(45) Mention de la délivrance du brevet :
**05.05.93 Bulletin 93/18**

(84) Etats contractants désignés :
**BE DE FR GB IT NL SE**

(56) Documents cités :
**DE-A- 3 337 834**
**FR-A- 2 330 204**

(56) Documents cités :
**MICROELECTRONICS, vol. 8, no. 3, mars 1977, pages 19-22, Mackintosh Publications Ltd, Luton, GB; J.K. FIDLER et al.: "Active filters incorporating the voltage-to-current transactor"**

(73) Titulaire : **SGS-THOMSON MICROELECTRONICS S.A.**
**7, Avenue Galliéni**
**F-94250 Gentilly (FR)**

(72) Inventeur : **Lemaire, Frédéric**
**14, Avenue de l'Europe**
**F-38120 Saint Egrève (FR)**

(74) Mandataire : **de Beaumont, Michel**
**1bis, rue Champollion**
**F-38000 Grenoble (FR)**

## Description

La présente invention concerne un circuit de compensation de l'atténuation d'un filtre coupe-bande à des fréquences inférieures à sa fréquence de coupure. Elle concerne plus particulièrement l'application d'un tel circuit dans le domaine de la téléphonie à un joncteur électronique d'abonné (couramment appelé SLIC d'après le sigle des termes anglo-saxons Sucriber Line Interface circuit ).

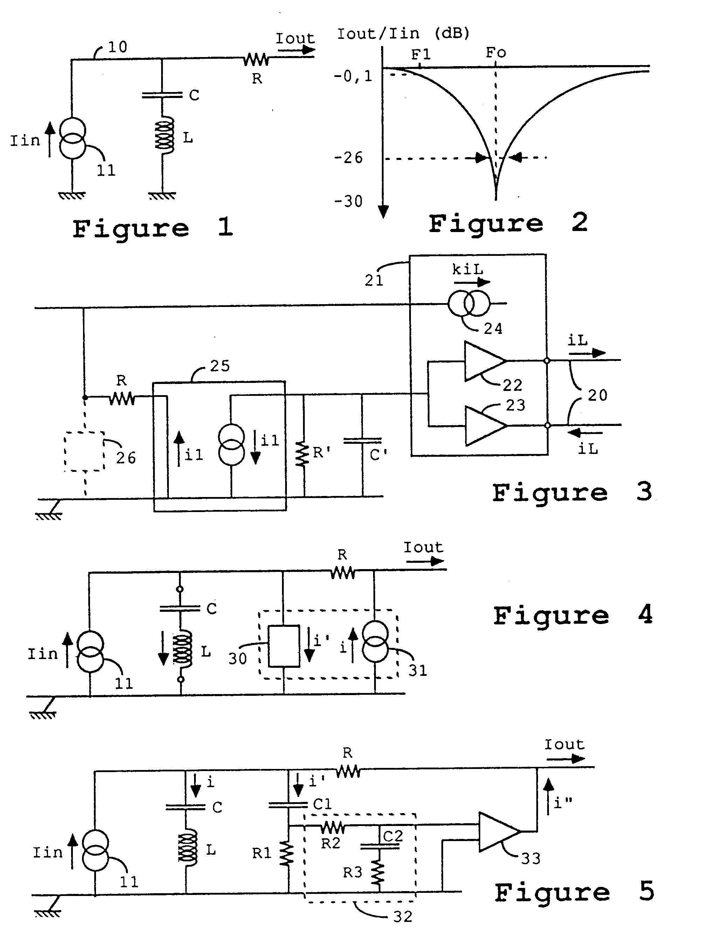

Les figures 1 à 3 sont destinées à illutrer le problème que la présente invention vise à résoudre.

La figure 1 représente une ligne 10 dans laquelle est interposée une résistance R et dans laquelle un courant $I_{in}$ est injecté par une source de courant 11. Un filtre LC série est connecté entre la ligne et une tension de référence (couramment la masse) pour éliminer une certaine fréquence $F_0$.

La courbe de réponse d'un filtre LC série est représentée schématiquement en figure 2. On voit que si l'atténuation est maximale, pour la fréquence $F_0$, elle est loin d'être négligeable à des fréquences éloignées de $F_0$. Par exemple, si $F_0$ est sensiblement égal à 15000 Hz, l'atténuation sera encore de 0,1 dB à une fréquence $F_1$ de l'ordre de 3500 Hz, la largeur de bande à 26 dB étant de l'ordre de 250 Hz.

On va illustrer dans le cadre d'une application particulière, les inconvénients d'un tel filtre.

La figure 3 représente très schématiquement un circuit de joncteur électronique d'abonné (SLIC). De tels circuits sont classiquement disposés au niveau d'un central téléphonique pour établir une connexion avec chaque ligne d'abonné 20. Ils sont notamment destinés à assurer une impédance de sortie donnée au niveau du central, par exemple avec les normes françaises une impédance résistive égale à 600 ohms dans la bande de 300 à 3400 Hz. La précision de cette impédance est définie par diverses normes et est caractérisée par une mesure dite d'affaiblissement d'adaptation RL (en anglais Return Loss). Cette mesure caractérise la différence entre l'impédance souhaitée Z0 et l'impédance réelle Z par la relation RL = 20log $|$ (Z-Z0)/(Z+Z0) $|$ . Cet affaiblissement d'atténuation RL est défini en France comme devant être meilleur que 20 dB.

Un joncteur électronique d'abonné est classiquement réalisé au moyen de un ou plusieurs circuits intégrés. Dans l'exemple représenté, il est prévu un premier circuit intégré 21 comprenant notamment des amplificateurs symétriques 22 et 23 de gain G attaquant la ligne et des moyens 24 pour mesurer le courant de ligne $i_L$ et fournir un signal de courant proportionnel à $i_L$, $ki_L$. Ce courant est renvoyé, par 'intermédiaire d'une résistance R et d'un miroir de courant 25 à une résistance R' qui applique une tension de contre-réaction sur l'entrée des amplificateurs 22 et 23, cette résistance étant en parallèle avec un condensateur C' destiné à assurer la stabilité de la boucle. Les éléments représentés dans le bloc 21 font par exemple partie d'un circuit intégré téléphonique commercialisé sous la référence TDB 7722 par la société SGS Thomson et le miroir de courant 25 fait partie d'un autre circuit intégré téléphonique commercialisé par la société SGS Thomson sous la référence TDB 7711.

Bien entendu, des moyens d'introduction du signal de parole à émettre ou de réception du signal de parole incident sont prévus dans les circuits intégrés sur des accès non représentés.

Ces divers cicuits donnent des fonctionnements très satisfaisants, à savoir un affaiblissement d'adaptation supérieur à 20 dB, dans la plage de 300 à 3400 Hz.

Dans certains cas, on souhaite adjoindre à un ensemble téléphonique un système de taxation à distance d'abonné (télétaxe). Pour cela, on est amené à émettre sur la ligne un signal haute fréquence, par exemple de l'ordre de 15000 Hz. Mais, comme pour ces fréquences élevées l'impédance du joncteur n'est pas adaptée, seul un signal très faible sera envoyé sur la ligne. Il a donc été envisagé dans l'art antérieur, d'ajouter un filtre, par exemple dans le bloc 26 représenté en pointillés en figure 3. Ce filtre permet de réduire l'impédance du joncteur à la fréquence du signal de taxation.

Toutefois, si l'on utilise comme cela est généralement le cas un filtre simple tel que celui représenté à la figure 1, on arrive à l'inconvénient présenté précédemment, à savoir que, dans la partie supérieure de la plage de fréquence utile (par exemple 300-3400 Hz), le signal est indûment atténué et le joncteur ne remplit plus de façon satisfaisante sa fonction d'adaptation d'impédance.

Pour éviter ces inconvénients résultant de l'introduction par un filtre coupe-bande d'une atténuation ou d'un déphasage gênant loin de sa fréquence de coupure, diverses solutions ont été proposées dans l'art antérieur :

- jouer sur les valeurs de C et L de façon à avoir un filtre plus étroit. Il en résulte un temps de réponse du filtre plus important ce qui constitue un autre inconvénient ;

- réaliser un filtre plus important en utilisant un réseau plus complexe d'inductances et de capacités. On se heurte alors à une autre difficulté. En effet, quand on veut réaliser les filtres en relation avec des circuits intégrés, l'inductance L est avantageusement réalisée à l'aide d'un condensateur et d'un circuit électronique dit gyrateur. En fait, un gyrateur est commode à réaliser si l'une des bornes de l'inductance est reliée à la masse. Sinon, dans le cas d'un filtre plus complexe comprenant des inductances non reliées à la masse, on se heurte à un problème difficile de réalisation d'inductances flottantes et cela entraîne l'utilisation d'un grand nombre d'amplificateurs opérationnels, c'est-à-dire un circuit intégré de grande dimension.

Ainsi, un objet de la présente invention est de résoudre le problème posé sans souffrir des inconvénients des dispositifs de l'art antérieur. Plus particulièrement, la présente invention vise à améliorer l'atténuation et le déphasage d'un filtre coupe-bande à des fréquences nettement inférieures à sa fréquence de coupure $F_0$ sans modifier le filtrage autour de la fréquence $F_0$, et ceci de manière peu coûteuse, en utilisant un filtre simple, ce filtre étant compatible avec une réalisation sous forme de circuit intégré.

Pour atteindre ces objets, la présente invention prévoit un circuit de compensation de l'atténuation provoquée sur une ligne par un filtre coupe-bande de type LC série, à des fréquences inférieures à la fréquence de coupure du filtre, le filtre étant connecté entre la ligne et une tension de référence, comprenant :

une première résistance en série sur la ligne,

un circuit série comprenant un condensateur et une deuxième résistance connecté entre la ligne et la tension de référence, le condensateur étant connecté du côté d'une première borne de la première résistance, et

un amplificateur de transconductance dont l'entrée est relié au point de connexion du condensateur et de la deuxième résistance et dont la sortie est reliée à la deuxième borne de la première résistance, cet amplificateur ayant une transconductance auxdites fréquences inférieures propre à assurer l'injection d'un courant égal à la somme des courants dérivés par le circuit série et par le filtre.

Selon un mode de réalisation de la présente invention, les première et deuxième résistances ont des valeurs sensiblement égales et le premier condensateur a une capacité sensiblement égale à celle du filtre coupe-bande.

Selon un mode de réalisation de la présente invention, le point de connexion du condensateur et de la deuxième résistance est relié à l'amplificateur par un filtre passe-bas.

Selon un mode de réalisation de la présente invention, le filtre passe-bas comprend une troisième résistance série de valeur élevée devant celle de la première résistance et la connexion en série vers la tension de référence d'un deuxième condensateur et d'une quatrième résistance.

La présente invention s'applique à un joncteur électronique d'abonné dans lequel le filtre coupe-bande est un filtre de télétaxe.

Ainsi, la présente invention permet, d'utiliser un filtre LC simple et de corriger l'atténuation apportée par ce circuit à des fréquences nettement inférieures à sa fréquence de coupure par des moyens simples facilement intégrables.

Un autre avantage de la présente invention dans le cadre de son application à un joncteur téléphonique d'abonné réside dans le fait que, même quand on n'utilise pas de filtre coupe-bande en relation avec un mode de taxation automatique, le coefficient d'affaiblissement d'adaptation est également amélioré aux fréquences téléphoniques utiles.

Ces objets caractéristiques et avantages ainsi que d'autres de la présente invention seront exposés plus en détail dans la description suivant de modes de réalisation particuliers faite en relation avec les figures jointes parmi lesquelles :

les figures 1 et 2 représentent respectivement un filtre coupe-bande LC classique et sa courbe de réponse ;

la figure 3 représente un joncteur d'abonné classique :

La figure 4 représente de façon très générale un circuit selon la présente invention ; et

la figure 5 représente de façon plus détaillée un mode de réalisation d'un circuit selon la présente invention.

Ainsi, la figure 4 illustre schématiquement les aspects fondamentaux de la présente invention.

Etant donné la ligne comprenant la résistance R, la source de courant $I_{in}$ et le filtre coupe-bande comprenant un condensateur C et une inductance L, déjà illustrés en figure 1, la présente invention prévoit des moyens pour fournir un courant $I_{out}$ à la sortie du circuit égal au courant $I_{in}$ fourni par la source de courant 11 en dessous de la zone de coupure du filtre 2. Ce circuit comprend fondamentalement un premier moyen 30 pour dériver un courant i' présentant une relation déterminée avec le courant i dans le filtre coupe-bande LC, et des moyens 31 pour réinjecter un courant i" égal à la somme des courants i et i'. Ce circuit 30, 31 agit pour des fréquences nettement inférieures à la fréquence de coupure du filtre LC et est inopératif au voisinage de cette fréquence de coupure.

La figure 5 représente un exemple de réalisation d'un tel circuit. Dans cette figure 5, de mêmes références désignent de mêmes éléments qu'en figures 1 et 4. Le circuit selon la présente invention comprend un circuit série, constitué d'un condensateur C1 et d'une résistance R1, relié entre l'entrée de la résistance R et la tension de référence (la masse) ; un filtre passe-bas 32 constitué par exemple d'une résistance série R2 et d'une dérivation comprenant un condensateur C2 et une résistance R3 ; et un amplificateur 33 auquel est reliée la borne de la résistance R2 à laquelle est connectée la dérivation C2, R3. Cet amplificateur 33 est commodément constitué d'un amplificateur de transconductance dont la deuxième entrée est reliée à la masse. La sortie de l'amplificateur 33 est reliée à la deuxième borne ou borne de sortie de la résistance R.

Avec un tel montage, quand on se trouve à une fréquence $F_1$ nettement inférieure à la fréquence de

coupure $F_0$ du filtre LC, l'impédance du condensateur C est nettement plus grande que l'impédance de l'inductance L et que celle de la résistance R. Ainsi, si l'on choisit C1 sensiblement égal à C et R1 sensiblement égal à R on aura i' = i et l'amplificateur 33 aura une transconductance gm = $2/R_1$. On a alors pour une fréquence $F_1$, nettement inférieure à $F_0$ un courant $i_{out}$ tel que :

$$i_{out} = i_{in} - i - i' + i'' = i_{in},$$

puisque i'' = i + i'.

Le filtre passe-bas R2, C2, R3 permet de rendre négligeable l'effet du dispositif à haute fréquence ce qui assure la stabilité de la boucle représentée en figure 3 et permet de maintenir la chute d'impédance recherchée par l'utilisation du filtre LC à la fréquence $F_0$.

Outre sa simplicité, le circuit selon l'invention présente l'avantage d'être peu sensible à la dispersion. En effet, une erreur de par exemple 10 % sur le courant i'' par rapport à sa valeur nominale apporte encore une amélioration de 14 dB sur la chute de courant produite par le filtre.

En se rappelant ce qui a été exposé en relation avec la figure 3 sur un joncteur d'abonné, l'invention trouve une application particulièrement utile dans ce cadre. Si la résistance R de la figure 3 est considérée comme correspondant à la résistance R des figures 4 et 5, le circuit selon l'invention peut être disposé à cet emplacement et résoudre les problèmes liés à l'adjonction de filtres de télétaxe à des joncteurs d'abonnés. On a constaté expérimentalement qu'en rajoutant un circuit selon la présente invention à celui de la figure 3, le paramètre d'affaiblissement d'adaptation RL passe seulement d'une valeur de 20 dB à une valeur de 19,5 dB, au lieu de chuter à une valeur de l'ordre de 15 dB avec un simple filtre LC.

Un autre avantage de l'invention, dans le cadre de l'application aux circuits de type SLIC, est qu'elle peut être utilisée même dans le cas où l'on n'utilise pas de filtre de télétaxe. L'invention permet alors d'améliorer l'atténuation d'adaptation vers les plus hautes fréquences de la bande de parole tout en gardant une bonne stabilité de boucle. En ce cas, une valeur du condensateur C1 de 3,9 nF fait passer le coefficient d'affaiblissement d'adaptation de 20 à 25 dB. En effet, on compense ainsi les pertes produites dans le condensateur C' par la réinjection de courant du circuit selon l'invention.

A titre d'exemple numérique, dans le cas où un circuit selon l'invention est adapté à un circuit SLIC muni d'un filtre de télétaxe centré sur une fréquence de 12 kHz, on pourra choisir les valeurs numériques suivantes :

C = C1 = 6,4 nF,
L = 27,3 mH,
R = R1 = 1 kilohm,
R2 = 100 kilohms,
C2 = 30 pF,
R3 = 30 kilohms.
gm = 2 millimhos.

Bien entendu, le circuit selon l'invention n'a été décrit qu'à titre d'exemple en relation avec la figure 5 et diverses variantes basées sur l'architecture générale décrite en relation avec la figure 4 pourront être adoptées.

## Revendications

1. Circuit de compensation de l'atténuation provoquée sur une ligne par un filtre coupe-bande de type LC série, à des fréquences inférieures à la fréquence de coupure du filtre, le filtre étant connecté entre la ligne et une tension de référence, caractérisé en ce qu'il comprend :

 une première résistance (R) en série sur la ligne,

 un circuit série comprenant un condensateur (C1) et une deuxième résistance (R1) connecté entre la ligne et la tension de référence, le condensateur étant connecté du côté d'une première borne de la première résistance, et

 un amplificateur (33) dont l'entrée est relié au point de connexion du condensateur et de la deuxième résistance et dont la sortie est reliée à la deuxième borne de la première résistance, cet amplificateur ayant une transconductance auxdites fréquences inférieures propre à assurer l'injection d'un courant égal à la somme des courants dérivés par le circuit série et par le filtre.

2. Circuit de compensation d'atténuation selon la revendication 1, caractérisé en ce que les première et deuxième résistances ont des valeurs sensiblement égales et en ce que le premier condensateur a une capacité sensiblement égale à celle du filtre coupe-bande.

3. Circuit de compensation d'atténuation selon la revendication 1, caractérisé en ce que le point de connexion du condensateur et de la deuxième résistance est relié à l'amplificateur par l'intermédiaire d'un filtre passe-bas (32).

4. Circuit de compensation d'atténuation selon la revendication 3, caractérisé en ce que ledit filtre passe-bas comprend une troisième résistance série (R2) de valeur élevée devant celle de la première résistance et la connexion en série vers la tension de référence d'un deuxième condensateur (C2) et d'une quatrième résistance (R3).

5. Circuit de compensation d'atténuation selon l'une quelconque des revendications 1 à 4, appliqué à un joncteur électronique d'abonné dans lequel le filtre coupe-bande est un filtre de télétaxe.

**Patentansprüche**

1. Schaltung zum Ausgleich der Dämpfung, die auf einer Leitung durch einen Bandsperrfilter vom LC-Serientyp hervorgerufem wird, bei Frequenzen niedriger als die Grenzfrequenz des Filters, wobei der Filter zwischen die Leitung und eine Referenzspannung geschaltet ist, dadurch gekennzeichnet, daß die Schaltung aufweist:

einen ersten Serienwiderstand (R) in der Leitung,

eine Serienschaltung aus einem Kondensator (C1) und einem zweiten Widerstand (R1), die zwischen die Leitung und die Referenzspannung geschaltet ist, wobei der Kondensator auf der Seite eines ersten Anschlusses des ersten Widerstandes angeschlossen ist, und

einen Verstärker (33), dessen Eingang mit dem Verbindungspunkt des Kondensators und des zweiten Widerstandes und dessen Ausgang mit dem zweiten Anschluß des ersten Widerstandes verbunden ist, wobei der Verstärker einen Gegenwirkleitwert bei den besagten niedrigen Frequenzen hat, der geeignet ist, das Einspeisen eines Stromes gleich der Summe der von der Serienschaltung und dem Filter entwickelten Ströme sicherzustellen.

2. Dämpfungsausgleichsschaltung nach Anspruch 1, dadurch gekennzeichnet, daß der erste und zweite Widerstand im wesentlichen den gleichen Widerstandswert aufweisen, und daß der erste Kondensator eine Kapazität im wesentlichen gleich der des Bandsperrfilters aufweist.

3. Dämpfungsausgleichsschaltung nach Anspruch 1, dadurch gekennzeichnet, daß der Verbindungspunkt des Kondensators und des zweiten Widerstandes mit dem Verstärker über einen Tiefpaßfilter (32) verbunden ist.

4. Dämpfungsausgleichsschaltung nach Anspruch 3, dadurch gekennzeichnet, daß der Tiefpaßfilter einen dritten Serienwiderstand (R2) mit einem gegenüber dem ersten Widerstand höheren Wert und eine Serienschaltung zur Referenzspannung aus einem zweiten Kondensator (C2) und einem vierten Widerstand (R3) aufweist.

5. Dämpfungsausgleichsschaltung nach einem der Ansprüche 1 bis 4, angewendet bei einer elektronischen Telefonschnittstelle, in der der Bandsperrfilter ein Filter in der Gebührenfernerfassung ist.

**Claims**

1. A compensation circuit for the attenuation caused on a line by a series LC type notch filter at frequencies less than the filter cut-off frequency, such filter being connected across the line and a reference voltage mode, characterized in this that it comprises:
   - a first resistor (R) in series in the line,
   - a series circuit comprising a capacitor (C1) and a second resistor (R1) connected across the line and the reference voltage mode, the capacitor being connected on the side of a first terminal of the first resistor, and
   - an amplifier (33), the input of which is connected to the junction of the capacitor and the second resistor, and the output of which is connected to the second terminal of the first resistor, such amplifier having a transconductance at said frequencies less than the filter cut-off frequency capable of ensuring the injection of current equal to the sum of the currents carried by said series circuit and said filter.

2. An attenuation compensation circuit according to claim 1, characterized in this that the first and second resistors have substantially equal values and the first capacitor has a capacitance substantially equal to that of said notch filter.

3. An attenuation compensation circuit according to claim 1, characterized in this that the junction of said capacitor and second resistor is connected to the amplifier through a low-pass filter (32).

4. An attenuation compensation circuit according to claim 3, characterized in this that said low-pass filter includes a third series resistor (R2) having a high value compared with that of the first resistor and a series connection to the reference voltage mode of a second capacitor (C2) and a fourth resistor (R3).

5. An attenuation compensation circuit according to any of claims 1 to 4, incorporated into an electronic subscriber interface wherein the notch filter is a remote charging filter.

Figure 1

Figure 2

Figure 3

Figure 4

Figure 5